(19) Europäisches Patentamt
European Patent Office
Office européen des brevets

(11) **EP 2 595 188 A1**

(12) **EUROPEAN PATENT APPLICATION**

(43) Date of publication:
**22.05.2013 Bulletin 2013/21**

(21) Application number: **11306510.6**

(22) Date of filing: **17.11.2011**

(51) Int Cl.:
**H01L 25/10** (2006.01)     **H01L 25/065** (2006.01)
**H01L 23/498** (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ST-Ericsson SA**
**1228 Plan-les-Ouates (CH)**

(72) Inventors:
• **Saint-Pierre, Jean-Marc**
**06130 Grasse (FR)**
• **Guillou, Yann**
**38100 Grenoble (FR)**

(74) Representative: **Hirsch & Associés**
**58, avenue Marceau**
**75008 Paris (FR)**

(54) **Circuitry package**

(57) A circuitry package (10) comprising:
- a first layer (12) comprising a first die (14) and electrical connections in relation with the first die (14) provided on both side of the first layer (12),
- a second layer (16) comprising a second die (20) in electrical relation with the first die (14), the second layer (16) being at least partially superimposed on the first layer (12) on a side of the first layer (12), the geometry of the second layer (16) being such that at least one electrical connection located on the side of the first layer (12) on which the second layer (16) being at least partially superimposed on the first layer (12) is accessible.

Such circuitry package (10) proposes a solution to the request for a single package system solution requiring both very thin and small packages and possibility to add an additional top package when two other dies are needed.

Fig.12

**Description**

FIELD OF THE INVENTION

The invention relates to a circuitry package, a system package and a mobile phone comprising such circuitry package.

BACKGROUND OF THE INVENTION

For manufacturers of semiconductor devices, there is a continuing desire to increase the density and reduce the size of the devices, so that more devices can be made on a single wafer of semiconductor material, and so that products that incorporate the devices can be made more compact. One response to this desire has been the development of chip scale packaging and wafer level packaging. These are packages that have a footprint that is very close to the actual area of the semiconductor die. They are generally direct surface mountable, using, e.g., ball grid arrays (also named after its acronym BGA) and flip chip configurations.

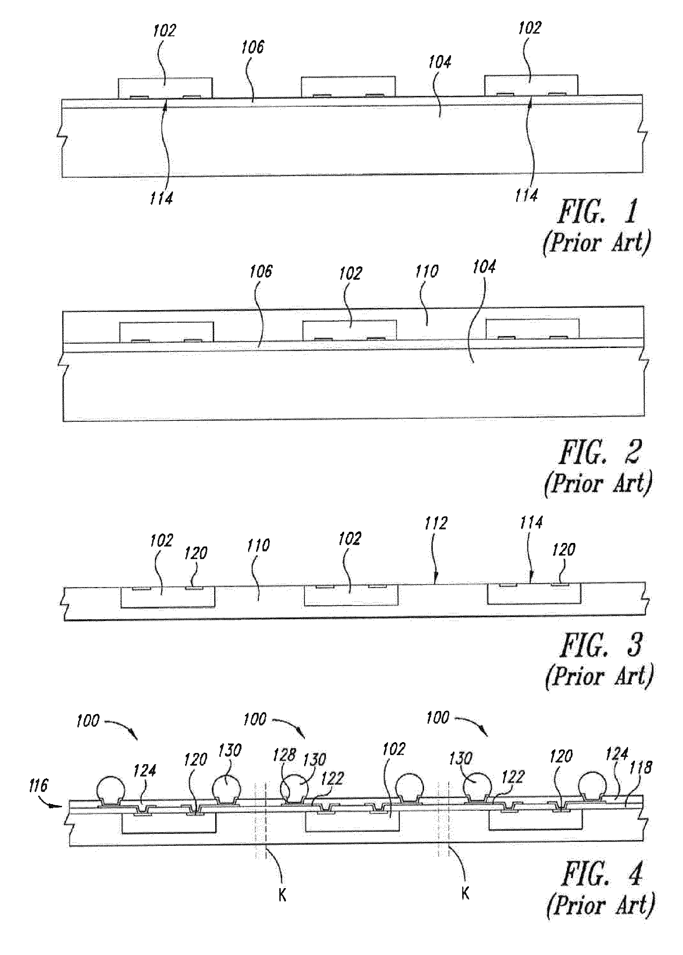

Another development is the reconfigured wafer, in which a semiconductor wafer is separated into individual dice, which are reformed into a reconfigured wafer, in which the dice are spaced some greater distance apart than on the original wafer, after which additional processing steps are performed on the devices. One benefit is that this provides increased area for each die for "back end" processes, such as the formation of contacts at a scale or pitch that is compatible with circuit board limitations, without sacrificing valuable real estate on the original wafer. Some packages of this type are sometimes referred to as a fan-out wafer level package (also named after its acronym FO-WLP), because the contact positions of the original die are "fanned out" to a larger foot print. A prior art method of manufacturing a fan-out package 100 is briefly outlined with reference to Figures 1 to 4.

As shown in Figures 1 and 2, dice 102 are individually positioned with their active faces 114 facing a laminate carrier strip 104, and held in position by an adhesive tape 106. A liquid molding compound is deposited over the dice 102 and subjected to a compression molding process during which the compound is cured into a hard layer 110. The molding compound is similar to the epoxy material commonly used to form conventional semiconductor packages.

After curing, the laminate carrier strip 104 and tape 106 are removed, leaving the layer 110 with a top surface 112 in which the original dice 102 are embedded with the active faces 114 of the dice exposed for additional connections, as shown in Figure 3. A redistribution layer 116 is then formed on the layer 110, as shown in Figure 4. A dielectric layer 118 is deposited over the top surface 112 and patterned to expose contact pads 120 of the original dice 102. A conductive layer is then deposited and patterned to form electrical traces 122. A second dielectric layer 124 is deposited and patterned, and a final conductive layer 126 is deposited and patterned to form redistributed contact pads 128. Solder bumps 130 are formed on the contact pads 128, and the layer 110 is cut at lines K, which define the kerf of the saw, to produce individual fan-out wafer level packages 100.

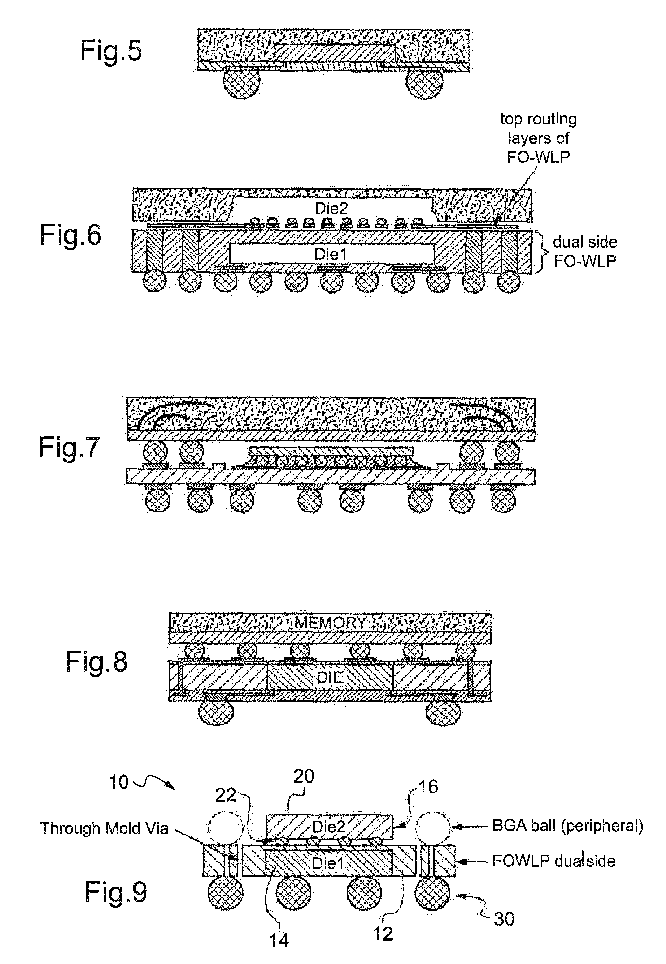

Figure 5 is another illustration of the package generated by using a FO-WLP technology on one side.

Therefore, the technology known as Fan-Out Wafer Level Package enables removing the traditional Ball Grid Array substrate. Furthermore, this technology provides for an artificial extension of the die dimension through usage of molded artificial wafer. Indeed more balls are fitted on the package while keeping a relatively small package solution. The package obtained with such technology can thus be made very small, with high pin out, relative to other integrated circuit (also named after its acronym IC) package types including traditional BGA packages.

A current move to tighter fabrication process technologies, such as 65 nm, with a continuing need to meet strict customer reliability requirements and ongoing cost pressures, is causing difficulties in implementing wafer-level package technology. For example, due to the small size of the die used in wafer-level packages, in some cases there is not enough space to accommodate all of the package pins at the pin pitch required for the end-use application. Furthermore, it is desired to include additional functionality in wafer-level packages. Including additional functionality in wafer-level BGA packages is difficult due to their small size.

A later improvement in FO-WLP technology is to use the FO-WLP technology for both sides. In that cases, vertical via through the mold compound and metalization are provided on top and bottom sides. This allows mounting a second flip chip die on top of the package. An example of such "dual side" FO-WLP technology is illustrated by Figure 6.

Multiple integrated circuit packages may be stacked upon one another to provide additional functionality in a package-on-package (also named after its acronym POP) structure. Such technique enables for example to add a memory on top of an existing chip. POP configuration is today identified as the mainstream configuration for application for engine processor (also named after its acronym APE) and application modem (also named after its acronym ModAp). Figure 7 illustrates such case. However, POP assembly techniques are difficult to implement in small integrated circuit packages. For example, current POP assembly techniques are not applicable to wafer-level integrated circuit packages.

The merge of the POP technology and dual-side FO-WLP technology has been proposed. An example is illustrated by Figure 8 notably by stacking a BGA memory package on top of a dual side FO-WLP. However, such merged technology does not propose a solution to the request for a single package system solution requiring both very thin and small packages and possibility to add an additional top package when two other dies are needed.

SUMMARY OF THE INVENTION

The object of the present invention is to alleviate at least partly the above mentioned drawbacks.

More particularly, the invention aims to propose a solution to the request for a single package system solution requiring both very thin and small packages and possibility to add an additional top package when two other dies are needed.

This object is achieved with a circuitry package comprising a first layer comprising a first die and electrical connections in relation with the first die provided on both side of the first layer. The circuitry package further comprises a second layer comprising a second die in electrical relation with the first die. The second layer is at least partially superimposed on the first layer on a side of the first layer. In addition, the geometry of the second layer is such that at least one electrical connection located on the side of the first layer on which the second layer is at least partially superimposed on the first layer is accessible.

Preferred embodiments comprise one or more of the following features:

- the thickness of the second die is inferior to 150 $\mu$m, preferably to 100 $\mu$m;
- the width of the second layer is inferior to the width of the first layer minus 100 $\mu$m, preferably minus 150 $\mu$m;
- the first layer comprises on at least one side electrical elements connected to the electrical connections of this side, the thickness of the second layer being inferior to the thickness of the electrical elements;
- the first layer comprises on at least one side electrical elements connected to the electrical connections of this side, the width of the second layer being inferior to the difference in width between the first layer and an electrical element, preferably to the difference in width between the first layer and two electrical elements;
- the electrical elements are balls;
- the second layer is fully superimposed on the first layer;
- the first layer is adapted to be connected to a printed circuit board;
- the first layer is a dual side layer obtained using a FO-WLP technology;
- the circuitry package is a bottom POP package for a POP connection to a top POP package.

The object is also achieved by a circuit package comprising a first layer. The first layer comprises a first die and electrical connections in relation with the first die provided on both side of the first layer. The circuit package also encompasses a third layer. This third layer comprises at least a third die in electrical relation with the first die, the third layer being at least partially superimposed on the first layer on a first side of the first layer. The circuit package further comprises a second layer. This second layer comprises a second die in electrical relation with the first die, the second layer being at least partially superimposed on the first layer on a side of the first layer.

Preferred embodiments comprise one or more of the following features:

- the thickness of the second die is inferior to 150 $\mu$m, preferably to 100 $\mu$m;
- the width of the second layer is inferior to the width of the first layer minus 100 $\mu$m, preferably minus 150 $\mu$m;
- the first layer comprises on at least one side electrical elements connected to the electrical connections of this side, the thickness of the second layer being inferior to the thickness of the electrical elements;
- the first layer comprises on at least one side electrical elements connected to the electrical connections of this side, the width of the second layer being inferior to the difference in width between the first layer and an electrical element, preferably to the difference in width between the first layer and two electrical elements;
- the electrical elements are balls;
- the second layer is fully superimposed on the first layer;
- the first layer is adapted to be connected to a printed circuit board;
- the first layer is a dual side layer obtained using a FO-WLP technology;
- the second layer is located between the first layer and the third layer;
- the thickness of the second layer is inferior to the distance between the first layer and the third layer.

It is further proposed a system package comprising the circuit package as previously described.

It is also considered s mobile phone comprising such system package.

Further features and advantages of the invention will appear from the following description of embodiments of the invention, given as non-limiting examples, with reference to the accompanying drawings listed hereunder.

BRIEF DESCRIPTION OF THE DRAWINGS

Fig. 1 to 4 are diagrammatic cross sections that show a prior art fan-out wafer level package, at various stages of manufacture,
Fig. 5 is a diagrammatic cross sections that show a fan-out wafer level package used for one side,
Fig. 6 shows a diagrammatic cross sections that show a fan-out wafer level package used for both sides,
Fig. 7 shows a diagrammatic cross sections that show the POP technology,
Fig. 8 shows a diagrammatic cross sections that show a merge of the POP technology and dual-side FO-WLP technology,
Fig. 9 to 12 show examples of circuitry package.

DETAILED DESCRIPTION OF THE INVENTION

It is proposed a circuitry package as illustrated on Figure 9. Such circuitry package 10 comprises a first layer 12.

First layer 12 comprises a first die 14. Such first die 14 may be a Power Management Unit (also named after its acronym PMU). Usually, it is preferable that PMU be close to the Printed Circuit Board (also named after its acronym PCB) due to power constraints. First layer 12 also comprises electrical connections in relation with first die 14. These electrical connections are not represented on Figure 9. The relationship between the electrical connections and first die 14 should be construed as an electrical one. An element connected in an electrical connection is thus in electrical relation with first die 14. The electrical connections are provided on both side of first layer 12. This implies that first die 14 can be connected on one side to a die or to the PCB and on the other side to a die or to a PCB.

For instance, first layer 12 may be a dual side layer obtained using a FO-WLP technology.

Circuitry package 10 also comprises a second layer 16. Second layer 16 comprises a second die 20 in electrical relation with first die 14. As an example, second die 20 is a modem die that may be connected to some external memories and PMU die (first die 14). According to the example of Figure 9, the electrical relation between first die 14 and second die 20 is achieved thank to bumps 22. Fours bumps 22 are represented on Figure 9. According to another embodiment, second die 20 may be both connected to first die 14 and PCB.

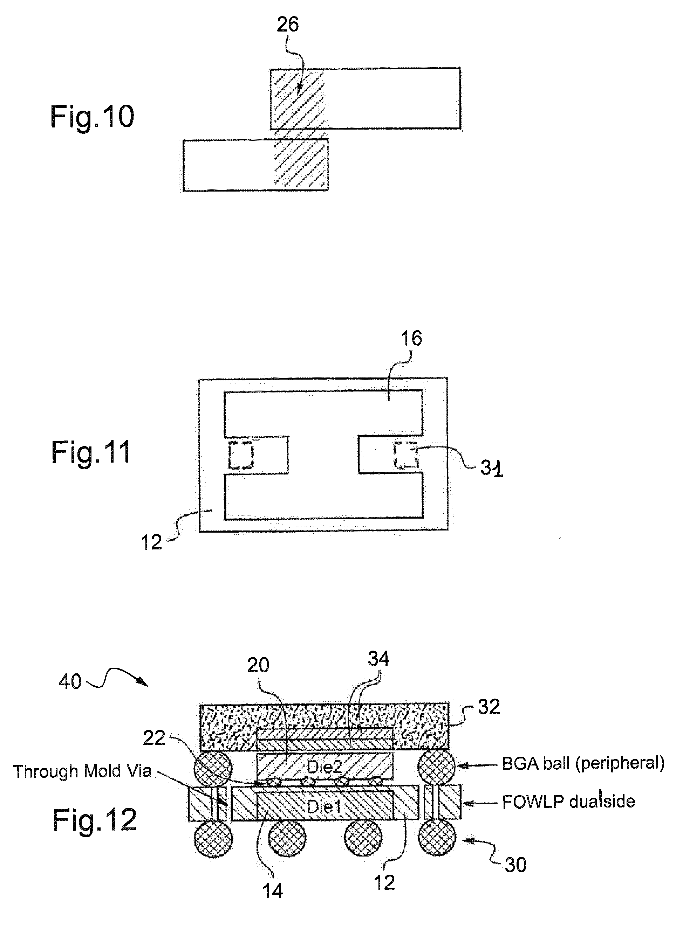

Second layer 16 is at least partially superimposed on first layer 12 on a first side 24 of first layer 12. Two layers are partially superimposed if they share a common area. They can thus extend outside the common area. This is schematically illustrated on Figure 10 wherein second layer 16 extends after the common area 26 represented with hatchings.

Furthermore, the geometry of second layer 16 is such that at least one electrical connection located on the first side of the first layer is accessible.

Such circuitry package 10 enables to obtain thinner circuitry package compared to a circuitry package wherein the two dies would be put side by side on the bottom side of FO-WLP (for a larger package) or wherein the second die outside the package would be located outside the package (not a system package solution).

So as to increase such effect, it is even better if second layer 16 is fully superimposed on first layer 12.

Many configurations may be considered such as the one of Figure 11 which proposes a H-form for the second layer 16. Figure 11 represents a circuitry package 10 seen from above wherein second layer 16 has substantially a H-form, electrical connections being accessible in the middle part of the H. Indeed, on both side of the central part of the H formed by second layer 16, it is possible to access to two electrical connections represented by squares 31 in dotted lines.

In addition, according to the example of Figure 9, first layer 12 comprises on at least one side electrical elements 30 connected to the electrical connections. There are four electrical elements 30 represented on Figure 9. Such electrical elements 30 may be characterized by their geometric shape or their dimension, for instance their thicknesses or their widths. For the remainder of the description, it will be considered that the electrical elements 30 are identical such that a same thickness noted $th_{electrical}$ elements and a same width noted $W_{electrical}$ elements can be defined for the electrical elements. It should be understood that in a case where the electrical elements 30 are different, the thickness noted $th_{electrical}$ elements may correspond to the mean value or the maximum value of the different thicknesses of electrical elements 30. The same apply for the width noted $W_{electrical}$ elements.

In the specific case of Figure 9, electrical elements 30 are balls. For this shape, the thickness and the width are equal. They both correspond to the diameter of the ball 30.

Usually, the same electrical elements 30 could be used for connection with the electrical connections located on the other side which is not provided with electrical elements 30. Therefore, the condition that geometry of second layer 16 is such that at least one electrical connection located on the first side of the first layer 12 is accessible may imply that the thickness of the second layer 16 be inferior to the thickness of the electrical elements 30. This can be expressed mathematically by the following relation:

$$\text{th}_{\text{second layer}} < \text{th}_{\text{electrical elements}} \quad (1)$$

where $\text{th}_{\text{second die}}$ is the thickness of second layer 16 and $\text{th}_{\text{electrical elements}}$ is the thickness of the electrical elements as defined previously.

For the example of Figure 9, as the thickness of second layer 16 corresponds to the sum of the thickness of second die 20 and the thickness of bumps 22, such condition of relation (1) may read:

$$\text{th}_{\text{second die}} + \text{th}_{\text{bumps}} < \text{th}_{\text{electrical elements}} \quad (2)$$

where $\text{th}_{\text{bumps}}$ is the thickness of bumps 22. As for the thickness of the electrical elements 30, in a case where the bumps 22 are different, the thickness noted $\text{th}_{\text{bumps}}$ may correspond to the mean value or the maximum value of the different thicknesses of the bumps 22.

Furthermore, for the specific case of Figure 9, the condition may be expressed as thickness of second layer 16 being inferior to the diameter of balls 30.

Alternatively, to achieve such suggested condition on thickness, the thickness of second die 20 may be inferior to 150 μm. Mathematically, this can be expressed as another condition (3):

$$\text{th}_{\text{second die}} < 150 \ \mu\text{m} \quad (3).$$

where $\text{th}_{\text{second die}}$ is the thickness of second die 20.

Similarly to what is shown when describing equation (2), it should be understood that such condition may also be expressed by giving a condition on the thickness of second layer 16 by including the thickness of bumps 22.

Preferably the value the thickness of second die 20 may be even more reduced so as to enable more connections to be established. For instance, it may be inferior to 100 μm. Mathematically, this can be expressed as:

$$\text{th}_{\text{second die}} < 100 \ \mu\text{m} \quad (4).$$

It can be noticed that these conditions (relations (3) and (4)) may apply both to a first layer 12 with the same electrical used for both sides or with different elements used for both sides.

Alternatively or in addition, the above-mentioned condition on the geometry of second layer 16 may imply that the width of the second layer 20 is inferior to the difference in width between the first layer 12 and an electrical element 30. This can be expressed mathematically by the following relation:

$$\text{W}_{\text{second layer}} < \text{W}_{\text{first layer}} - \text{W}_{\text{electrical elements}} \quad (5)$$

where $\text{W}_{\text{second layer}}$ is the width of second layer 16, $\text{W}_{\text{first layer}}$ is the width of first layer 12 and $\text{W}_{\text{electrical elements}}$ is the width of the electrical elements as defined previously.

According to the case of Figure 9, the width of the second layer 16 corresponds to the width of second die 20. Thus, in relation (5), for Figure 9, $\text{W}_{\text{second layer}}$ can be replaced by $\text{W}_{\text{second die}}$. Should such condition be fulfilled, it would then be possible to put a connection element in a configuration with two dies in a reduced volume. In

Figure 9, such possibility is symbolized by ball represented in dashed lines.

Preferably, the above-mentioned condition on the geometry of second layer 16 may imply that the width of the second layer 20 is inferior to the difference in width between the first layer 12 and two electrical elements 30. This can be expressed mathematically by the following relation:

$$W_{\text{second layer}} < W_{\text{first layer}} - 2.W_{\text{electrical elements}} \quad (6)$$

where $W_{\text{second layer}}$ is the width of second layer 16, $W_{\text{first layer}}$ is the width of first layer 12 and $W_{\text{electrical elements}}$ is the width of the electrical elements as defined previously.

Fulfilling such relation (6) enables to put two eletrcial elements in a configuration with two dies in a reduced volume. Two electrical elements enable to obtain a better electrical relation with the first die than a connection involving only one electrical element.

According to the example of Figure 9 wherein the width of the second layer 20 is inferior to the difference in width between the first layer 12 and two electrical elements and the center of the second layer is placed above the center of the first layer, an electrical element may be placed on each side of the second layer, one on its left and another one on its right. In Figure 9, such possibility is symbolized by ball represented in dashed lines.

Alternatively, to achieve the suggested condition on width, the width of second layer 16 may be inferior to the width of first layer 12 minus 100 $\mu$m. Mathematically, this can be expressed as:

$$W_{\text{second layer}} = W_{\text{first layer}} - 100 \ \mu\text{m} \quad (7)$$

where $W_{\text{second layer}}$ is the width of second layer 16 and $W_{\text{first layer}}$ is the width of first layer 12.

Preferably the value the width of second layer 16 may be even more reduced so as to enable more connections to be established. For instance, it may be inferior to the width of the first layer minus 150 $\mu$m. Mathematically, this can be expressed as:

$$W_{\text{second layer}} = W_{\text{first layer}} - 150 \ \mu\text{m} \quad (8)$$

It can be noticed that these conditions may apply both to a first layer 12 with the same electrical elements used for both sides or with different elements used for both sides. Such circuitry package 10 may be a bottom POP package for a POP connection to a top POP package.

Figure 12 is a schematically lateral view of a circuit package comprising the bottom POP package of Figure 9 and a top POP package.

Such circuit package 40 may also be described with the description of each layer and their relation between themselves.

Circuit package 40 comprises first layer 12. First layer 12 comprises first die 14 and electrical connections in relation with first die 14 provided on both side of first layer 12.

Circuit package 40 further comprises a third layer 32 comprising at least a third die 34 in electrical relation with first die 14, the third layer 32 being at least partially superimposed on first layer 12 on a first side of first layer 12. For instance, third die 34 may be an external memory. Such memory may be of the Low Power Dual Data Rate 2 (also named after its acronym LP-DDR2). According to the example of Figure 12, the third die 34 comprises two external memories.

Circuit package 40 also encompasses a second layer 20 comprising the second die 22 in electrical relation with first die 14, second layer 20 being at least partially superimposed on first layer 12 on a side of first layer 12.

Such circuitry package 40 provides a solution to the request for a single package system solution requiring both very thin and small packages and possibility to add an additional top package when two other dies are needed. In other words, circuitry package 40 provides thinner package, smaller size of package (comparing to putting two dies side by side on bottom of FO-WLP), still keeping good connection between third die 34 and second die 22 which are on top of each other like in regular POP and good connection of first die 12 to PCB (for example a PMU).

Should the FO-WLP technology be used to generate the second layer, it is therefore proposed to merge the two concepts of FO-WLP double side technology and POP technology, into a new package structure in order to fit the need of advanced system package products.

Second layer 20 may be superimposed on first layer 12 either on the first side of first layer 12 or on the side which is opposite to the first side of first layer 12. In the case that the superimposition is achieved on the first side of first layer 12, second layer 20 is located between first layer 12 and third layer 32. Such configuration enables to include a second die flip chip on top side of first layer 12 without increasing the final thickness of circuit package 40.

Furthermore, in such situation, the thickness of second layer 20 may be inferior to the distance between first layer 12 and third layer 32. Should the distance between first layer 12 and third layer 32 be labeled d, this relation implies that:

$$th_{second\ layer} < d\ (8)$$

where $th_{second}$ die is the thickness of second layer 16.

The circuitry package 10 or the circuitry package 40 may be a part of a system package or a mobile phone. The proposed circuitry packages indeed enable to obtain high density and thin system package solution for Modem products.

The invention has been described with reference to preferred embodiments. However, many variations are possible within the scope of the invention.

| APPENDICE I: TABLE OF ACRONYMS | |
|---|---|
| **ACRONYMS** | **MEANING** |
| APE | Applucation for Engine Processor |
| BGA | Ball Grid Array |
| FO-WLP | Fan-Out Wafer Level Package |
| IC | Integrated Circuit |
| LP-DDR2 | Low Power Dual Data Rate 2 |
| ModAp | Application Modem |
| PCB | Printed Circuit Board |
| PMU | Power Management Unit |
| POP | Package on Package |

**Claims**

1. A circuitry package (10) comprising:

   - a first layer (12) comprising a first die (14) and electrical connections in relation with the first die (14) provided on both side of the first layer (12),
   - a second layer (16) comprising a second die (20) in electrical relation with the first die (14), the second layer (16) being at least partially superimposed on the first layer (12) on a side of the first layer (12), the geometry of the second layer (16) being such that at least one electrical connection located on the side of the first layer (12) on which the second layer (16) being at least partially superimposed on the first layer (12) is accessible.

2. The circuitry package according to claim 1, wherein the thickness ($th_{second\ die}$) of the second die (20) is inferior to 150 $\mu$m, preferably to 100 $\mu$m.

3. The circuitry package according to claim 1 or claim 2, wherein the width ($W_{second\ layer}$) of the second layer (16) is inferior to the width ($W_{first\ layer}$) of the first layer (14) minus 100 $\mu$m, preferably minus 150 $\mu$m.

4. The circuitry package according to any one of claim 1 to 3, wherein the first layer (12) comprises on at least one side electrical elements (30) connected to the electrical connections of this side, the thickness ($th_{second\ layer}$) of the second layer (16) being inferior to the thickness ($th_{connection\ elements}$) of the electrical elements (30).

5. The circuitry package according to any one of claim 1 to 4, wherein the first layer (12) comprises on at least one side electrical elements (30) connected to the electrical connections of this side, the width ($W_{second\ layer}$) of the second layer (16) being inferior to the difference in width between the first layer (14) and a electrical element (30), preferably to the difference in width between the first layer (14) and two electrical elements (30)

**6.** The circuitry package according to claim 4 or claim 5, wherein the electrical elements (30) are balls.

**7.** The circuitry package according to any one of claim 1 to claim 6, wherein the second layer (20) is fully superimposed on the first layer (14).

**8.** The circuitry package according to any one of claim 1 to claim 7, wherein the first layer (14) is a dual side layer obtained using a FO-WLP technology.

**9.** The circuitry package according to any one of claim 1 to claim 8, the circuitry package (10) being a bottom POP package for a POP connection to a top POP package.

**10.** A circuit package (40) comprising:

- a first layer (12) comprising a first die (14) and electrical connections in relation with the first die (14) provided on both side of the first layer (12),
- a third layer (32) comprising at least a third die (34) in electrical relation with the first die (14), the third layer (32) being at least partially superimposed on the first layer (12) on a first side of the first layer (12),
- a second layer (16) comprising a second die (20) in electrical relation with the first die (14), the second layer (16) being at least partially superimposed on the first layer (12) on a side of the first layer (12).

**11.** The circuit package according to claim 10, wherein the second layer (16) is located between the first layer (12) and the third layer (32).

**12.** The circuit package according to claim 10 or claim 11, wherein the thickness ($th_{second}$ layer) of the second layer (16) is inferior to the distance (d) between the first layer (12) and the third layer (32).

**13.** The circuit package according to any one of claim 10 to claim 12, wherein the thickness ($W_{second\ layer}$) of the second die (20) is inferior to 150 $\mu$m, preferably to 100 $\mu$m.

**14.** A system package comprising the circuit package according to any one of claim 1 to claim 13.

**15.** A mobile phone comprising the system package of claim 14.

FIG. 1
(Prior Art)

FIG. 2
(Prior Art)

FIG. 3
(Prior Art)

FIG. 4
(Prior Art)

**Fig.5**

**Fig.6**

top routing
layers of
FO-WLP

Die2

dual side
FO-WLP

Die1

**Fig.7**

**Fig.8**

MEMORY

DIE

**Fig.9**

10

22

20

16

Through Mold Via

Die2

BGA ball (peripheral)

Die1

FOWLP dual side

30

14

12

Fig.10

26

Fig.11

16

31

12

40

20    34

32

22

Through Mold Via

BGA ball (peripheral)

Die2

FOWLP dualside

Fig.12

Die1

30

14    12

Europäisches
Patentamt

European
Patent Office

Office européen
des brevets

**EUROPEAN SEARCH REPORT**

Application Number

EP 11 30 6510

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 1 612 860 A2 (SHINKO ELECTRIC IND CO [JP]) 4 January 2006 (2006-01-04) * paragraph [0019] - paragraph [0029]; figures 1-3 * | 1-15 | INV. H01L25/10 H01L25/065 H01L23/498 |
| Y | US 2006/175702 A1 (ISHIBASHI KAZUO [JP]) 10 August 2006 (2006-08-10) * figure 3 * | 1-15 | |
| Y | US 2010/072599 A1 (CAMACHO ZIGMUND R [SG] ET AL) 25 March 2010 (2010-03-25) * paragraph [0083]; figure 12 * | 1-15 | |
| Y | US 2010/244219 A1 (PAGAILA REZA ARGENTY [SG] ET AL) 30 September 2010 (2010-09-30) * figures 2-5 * | 1-15 | |
| | | | TECHNICAL FIELDS SEARCHED (IPC) H01L |

The present search report has been drawn up for all claims

| Place of search | Date of completion of the search | Examiner |
|---|---|---|
| Munich | 23 February 2012 | Cortes Rosa, João |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 11 30 6510

This annex lists the patent family members relating to the patent documents cited in the above-mentioned European search report.
The members are as contained in the European Patent Office EDP file on
The European Patent Office is in no way liable for these particulars which are merely given for the purpose of information.

23-02-2012

| Patent document cited in search report | | Publication date | Patent family member(s) | | Publication date |
|---|---|---|---|---|---|
| EP 1612860 | A2 | 04-01-2006 | CN | 1716587 A | 04-01-2006 |
| | | | EP | 1612860 A2 | 04-01-2006 |
| | | | JP | 4343044 B2 | 14-10-2009 |
| | | | JP | 2006019368 A | 19-01-2006 |
| | | | US | 2006001179 A1 | 05-01-2006 |
| | | | US | 2006263937 A1 | 23-11-2006 |
| US 2006175702 | A1 | 10-08-2006 | US | 2006175702 A1 | 10-08-2006 |
| | | | WO | 2006109120 A1 | 19-10-2006 |
| US 2010072599 | A1 | 25-03-2010 | NONE | | |
| US 2010244219 | A1 | 30-09-2010 | KR | 20100108296 A | 06-10-2010 |
| | | | TW | 201108334 A | 01-03-2011 |
| | | | US | 2010244219 A1 | 30-09-2010 |